# EUROPÄISCHE PATENTSCHRIFT

(11) **EP 1 002 366 B1**
(45) Veröffentlichungstag und Bekanntmachung des Hinweises auf die Patenterteilung: **28.11.2001**
(21) Anmeldenummer: 98913724.5
(22) Anmeldetag: 17.03.1998
(51) Int. Cl.: H03K 17/082

(54) **SCHALTUNGSANORDNUNG ZUM SCHALTEN VON LASTEN**
CIRCUIT FOR THE SWITCHING OF LOADS
CIRCUIT DE COMMUTATION DE CHARGES

(30) Priorität: 16.08.1997 DE 19735543
(43) Veröffentlichungstag der Anmeldung: 24.05.2000
(73) Patentinhaber: ROBERT BOSCH GMBH, 70442 Stuttgart (DE)
(72) Erfinder: KOELSCH, Volker, D-70599 Stuttgart (DE); TOPP, Rainer, D-72768 Reutlingen (DE)
(86) Internationale Anmeldenummer: EP9801538
(87) Internationale Veröffentlichungsnummer: WO9909652

(56) Entgegenhaltungen:
- EP-A- 0 609 158
- EP-A- 0 717 497
- DE-A- 3 924 988
- DE-A- 4 321 971

## Beschreibung

### Stand der Technik

Die Erfindung geht aus von einer Schaltungsanordnung zum Schalten von Lasten nach dem Oberbegriff des Patentanspruchs 1.

Eine derartige Anordnung wird im Dokument DE-A-3924988 beschrieben: Der Kurzschluß einer der MOSFET-Endstufen wird über einen Fensterdiskriminator regelmäßig getestet. Dabei wird die Spannungsversorgung der nachgeschaltet MOSFET-Endstufe durch den Fensterdiskriminator überwacht.

Beim Schalten von sicherheitsrelevanten Lasten bspw. im KFZ-Bereich sind kritische Betriebszustände aufgrund eines Defekts des Schalters unbedingt zu vermeiden. Daher werden zum Schalten solcher Lasten in der Regel Schaltungsanordnungen mit zwei unabhängigen, in Reihe geschalteten Halbleiterschaltern verwendet, so daß eine gewisse Redundanz gegeben ist. Bei diesem bekannten Konzept dient einer der Schalter zum Schalten der Last, während der andere als "Notausschalter" fungiert. Der "Notausschalter" überwacht die Funktionsfähigkeit des die Last schaltenden Schalters. Eine Überwachung der Funktionsfähigkeit des "Notausschalters" ist hier nicht vorgesehen.

Erfindungsgemäß wird eine Schaltungsanordnung mit mindestens zwei in Reihe geschalteten, jeweils über eine Logikschaltung ansteuerbaren MOSFET-Endstufen vorgeschlagen, bei der eine gegenseitige Überwachung der beiden MOSFET-Endstufen realisiert ist, so daß im Falle des Kurzschlusses einer der beiden MOSFET-Endstufen ein Einschalten der Last verhindert wird.

### Vorteile der Erfindung

Da bei der hier in Rede stehenden Schaltungsanordnung die Spannungsversorgung der nachgeschalteten MOSFET-Endstufe über die erste MOSFET-Endstufe erfolgt, läßt sich ein Kurzschluß der nachgeschalteten MOSFET-Endstufe einfach durch Überwachen ihrer Versorgungsspannung beim Einspeisen von kleinen Testströmen realisieren. Dazu sind erfindungsgemäß Mittel vorgesehen, die durch ein Einschaltsignal (INPUT) aktiviert werden und ein Einschalten der ersten MOSFET-Endstufe verhindern, wenn die Versorgungsspannung der nachgeschalteten MOSFET-Endstufe unterhalb eines vorbestimmten Wertes liegt.

Zur Überprüfung, ob ein Kurzschluß der ersten MOSFET-Endstufe vorliegt, umfaßt die erfindungsgemäße Schaltungsanordnung eine Verbindungsleitung zwischen den Logikschaltungen der beiden MOSFET-Endstufen, über die eine Eingangsspannung an der Logikschaltung der nachgeschalteten MOSFET-Endstufe anliegt. Wird nun die erste MOSFET-Endstufe aufgrund des INPUT-Signals eingeschaltet, so wird diese Eingangsspannung definiert verändert. im Falle eines Kurzschlusses der ersten MOSFET-Endstufe ist zwar eine ausreichende Versorgungsspannung für die nachgeschaltete MOSFET-Endstufe vorhanden, die an der Systemlogik der nachgeschalteten MOSFET-Endstufe anliegende Eingangsspannung weicht aber von der den Normalzustand definierenden Eingangsspannung ab. Dadurch läßt sich der Fehler-Fall einfach detektieren und ein Einschalten der nachgeschalteten MOSFET-Endstufe und also der Last verhindern.

Das erfindungsgemäße Schaltungskonzept ermöglicht eine parallele Überwachung der Funktionsfähigkeit beider MOSFET-Endstufen. Da ein Einschalten der Last schon bei einem Defekt einer der beiden MOSFET-Endstufen verhindert wird, lassen sich kritische Betriebszustände der nachgeschalteten Last zuverlässig vermeiden.

In einer vorteilhaften Ausgestaltung der erfindungsgemäßen Schaltungsanordnung wird zusätzlich zu einem Kurzschluß der ersten MOSFET-Endstufe auch der Fall einer gleichzeitigen Beschädigung der zugehörigen Systemlogik berücksichtigt und auch in diesem Fall eine Einschalten der Last verhindert. Dazu umfaßt die erfindungsgemäße Schaltungsanordnung bzw. die Systemlogik der ersten MOSFET-Endstufe Mittel zum Takten der Eingangsspannung. Mit Hilfe der Systemlogik der nachgeschalteten MOSFET-Endstufe werden die Schaltflanken im Signal der Eingangsspannung detektiert und ein Abschalten der Last bewirkt, wenn die Schaltflanken ausbleiben. Hier wird also durch Taktauswertung des Eingangssignals zusätzlich auch die Funktionsfähigkeit der Systemlogik der ersten MOSFET-Endstufe geprüft.

### Zeichnungen

Es gibt nun verschiedene Möglichkeiten für die schaltungstechnische Realisierung der voranstehend angegebenen einzelnen Funktionen der erfindungsgemäßen Schaltungsanordnung zum Schalten von Lasten. Besonders vorteilhafte Ausführungsformen der Erfindung sind in den Zeichnungen dargestellt und in der nachfolgenden Beschreibung näher erläutert. Es zeigen
- Fig. 1: den prinzipiellen Aufbau einer erfindungsgemäßen Schaltungsanordnung,
- Fig. 2: eine Ausführungsform des Schaltungsteils, der zur Überwachung der nachgeschalteten MOSFET-Endstufe dient,
- Fig. 3: eine Ausführungsform. des Schaltungsteils, der zur Überwachung der ersten MOSFET-Endstufe dient,
- Fig. 4: eine Erweiterung des in Fig. 2 dargestellten Schaltungsteils zur Überwachung der Funktionsfähigkeit der Systemlogik der ersten MOSFET-Endstufe und
- Fig. 5: eine entsprechende Erweiterung des in Fig. 3 dargestellten Schaltungsteils.

### Beschreibung des Ausführungsbeispiels

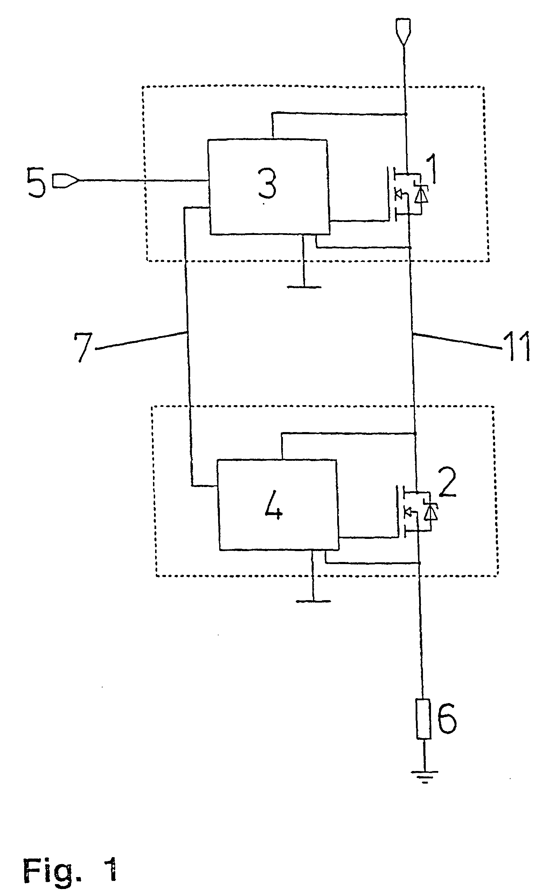

In Fig. 1 ist der prinzipielle Aufbau einer erfindungsgemäßen Schaltungsanordnung zum Schalten von Lasten dargestellt. Die Schaltungsanordnung umfaßt zwei in Reihe geschaltete MOSFET-Endstufen 1 und 2, die jeweils über eine Logikschaltung 3 und 4 ansteuerbar sind. Ein Einschaltsignal (INPUT) 5, über das das Ein-/Ausschalten der MOSFET-Endstufen 1 und 2 und damit auch der nachgeschalteten Last 6 ausgelöst wird, wird der ersten MOSFET-Endstufe 1 zugeführt. Die Spannungsversorgung der nachgeschalteten MOSFET-Endstufe 2 erfolgt über die erste MOSFET-Endstufe 1, und zwar nur dann, wenn die erste MOSFET-Endstufe 1 eingeschaltet ist.

Erfindungsgemäß ist zusätzlich eine Verbindungsleitung 7 zwischen den Logikschaltungen 3 und 4 vorgesehen, über die eine Eingangsspannung (EN) an der Logikschaltung 4 der nachgeordneten MOSFET-Endstufe 2 anliegt.

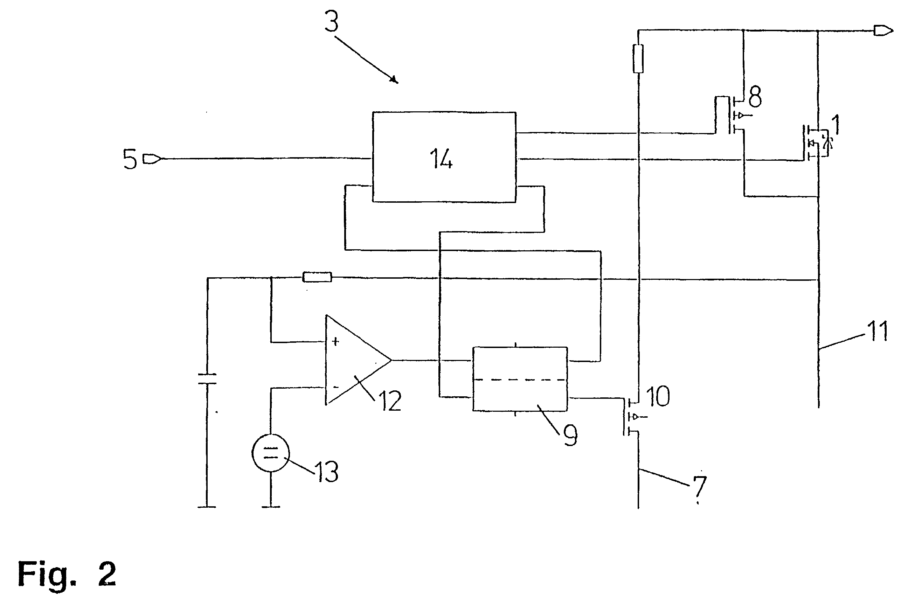

In Verbindung mit Fig. 2 wird nachfolgend die Überwachung der nachgeschalteten MOSFET-Endstufe 2 erläutert.

Durch das INPUT-Signal 5 wird zunächst nur ein parallel zur MOSFET-Endstufe 1 geschalteter Transistor 8 eingeschaltet, der einen definierten Strom liefert. Die erste MOSFET-Endstufe 1 bleibt zunächst genauso wie die nachgeschaltete MOSFET-Endstufe 2 ausgeschaltet. So lange die erste MOSFET-Endstufe 1 ausgeschaltet ist, befindet sich ein Flip-Flop 9 im Reset-Zustand, d.h. der Ausgang QN = High. Dadurch ist ein nachgeschalteter Transistor 10 gesperrt und die Verbindungsleitung 7 zu der Systemlogik 4 der nachgeschalteten MOSFET-Endstufe 2 befindet sich auf dem Potential EN = Low.

Da der vom Transistor 8 gelieferte Strom größer ist als der Ruhestrom der nachgeschalteten MOSFET-Endstufe 2 und der zugehörigen Systemlogik 4, steigt das Potential (LOAD1) der Verbindungsleitung 11 zwischen den beiden MOSFET-Endstufen 1 und 2 gegenüber Masse an. LOAD1 stellt die Versorgungsspannung der nachgeschalteten MOSFET-Endstufe 2 dar. Dieser Potentialanstieg wird mit Hilfe eines Komparators 12 detektiert, an dessen einem Eingang das Potential LOAD1 anliegt, während der andere Eingang an eine Vergleichsspannung (Vs) 13 angeschlossen ist. Überschreitet das Potential LOAD1 die Vergleichsspannung Vs 13, so wird über den Komparator 12 das Flip-Flop 9 gesetzt, so daß der Ausgang Q = ok = High und die MOSFET-Endstufe 1 eingeschaltet wird. Gleichzeitig wird über den Ausgang QN = Low des Flip-Flops 9 der Transistor 10 aktiviert, so daß die Eingangsspannung EN = High wird. Wenn sowohl die MOSFET-Endstufe 1 eingeschaltet ist als auch die Eingangsspannung EN = High ist, wird auch die nachgeschaltete MOSFET-Endstufe 2 eingeschaltet.

Im Fehlerfalle, d.h. beim Auftreten eines Kurzschlusses der nachgeschalteten MOSFET-Endstufe 2, erfolgt nach dem Einschalten des Transistors 8 kein Anstieg des Potentials LOAD1, da dieses über die kurzgeschlossene MOSFET-Endstufe 2 und die nachgeschaltete Last 6 auf Massepotential gehalten wird. Der vom Transistor 8 gelieferte Strom ist dabei so niedrig, daß er keinen nennenswerten Spannungsabfall (> Vs) über der Last 6 verursacht. Da kein Anstieg des Potentials LOAD1 detektiert wird, bleibt das Flip-Flop 9 im Reset-Zustand. Damit bleibt auch die MOSFET-Endstufe 1 abgeschaltet und im Ergebnis auch die nachgeschaltete Last 6.

Mit 14 ist ein Systemschaltungsteil bezeichnet, das anwendungsspezifische Funktionen und daneben auch diverse Schutzfunktionen enthält, wie z.B. Schutzfunktionen gegen Übertemperatur. Lastkurzschluß, Überspannungen usw.. Das Systemschaltungsteil 14 liefert ferner die Ansteuersignale für den Transistor 8 und die MOSFET-Endstufe 1 sowie das Reset-Signal für das Flip-Flop 9. Außerdem wertet das Systemschaltungsteil 14 das OK-Signal des Flip-Flops 9 aus, d.h. die MOSFET-Endstufe 1 wird nur eingeschaltet, wenn OK = High ist.

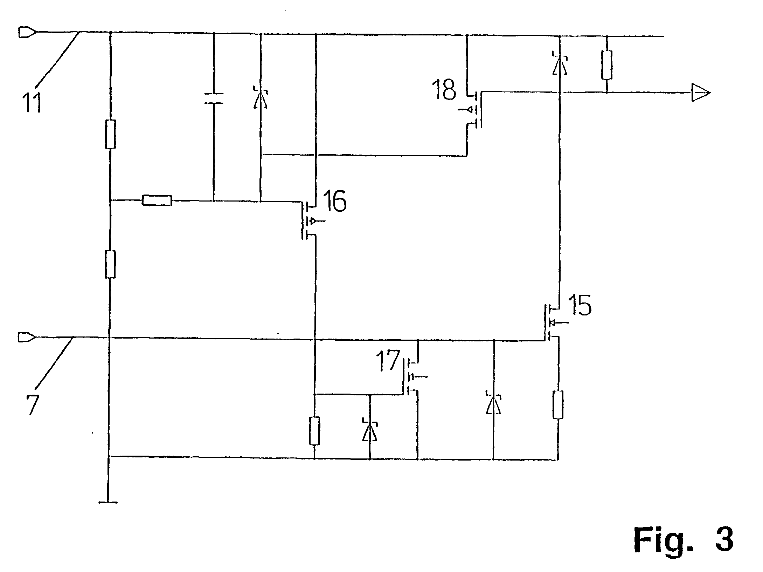

In Verbindung mit Fig. 3 wird nachfolgend die Überwachung der MOSFET-Endstufe 1 erläutert.

Wie bereits erwähnt erfolgt die Spannungsversorgung der nachgeschalteten MOSFET-Endstufe 2 und der zugehörigen Systemlogik 4 über die erste MOSFET-Endstufe 1. Beim normalen Einschaltvorgang, d.h. bei funktionsfähiger MOSFET-Endstufe 1, liegt die Versorgungsspannung LOAD1 erst in dem Moment an, wenn die MOSFET-Endstufe 1 zusammen mit der zugehörigen Systemlogik 3 über das INPUT-Signal 5 aktiviert ist. In diesem Falle wird ein Transistor 15 über die Eingangsspannung EN = High eingeschaltet. Dadurch wird auch die MOSFET-Endstufe 2 eingeschaltet.

im Falle eines Kurzschlusses der ersten MOSFET-Endstufe 1 liegt die nachgeschaltete MOSFET-Endstufe 2 zusammen mit der zugehörigen Systemlogik 4 an Spannung, obwohl die Eingangsspannung auf Low-Potential liegt. In diesem Falle wird ein Transistor 16 eingeschaltet, bevor die Eingangsspannung von Low auf High wechselt. Dadurch wird ein Transistor 17 eingeschaltet, der den Transistor 15 sperrt. Auf diese Weise kann selbst bei einer Eingangsspannung EN = High der Transistor 15 nicht mehr eingeschaltet werden, so daß die MOSFET-Endstufe 2 abgeschaltet bleibt.

Um nun das gleichzeitige Ansprechen der Transistoren 15 und 16 zu verhindern, umfaßt die hier dargestellte Schaltungsanordnung zusätzlich einen Transistor 18, der zusammen mit dem Transistor 15 aktiviert wird, so daß der Transistor 16 nicht mehr einschalten kann, wenn der Transistor 15 eingeschaltet ist. Um nun die richtige Schaltfolge der Transistoren 15 und 16 sicherzustellen, sieht die Schaltungsanordnung eine Einschaltverzögerung in Form eines R/C-Zeitgliedes für den Transistor 16 vor. Außerdem wird der Transistor 17 immer nur dann aktiviert, wenn der Transistor 16 eingeschaltet ist, und sperrt dann den Transistor 15. Wichtig in diesem Zusammenhang ist, daß die Einschaltverzögerung des Transistors 16 so groß ist, daß im fehlerfreien Falle immer die Transistoren 15 und 18 vorher eingeschaltet werden.

Tritt nun in der Einschaltphase der MOSFET-Endstufen 1 und 2 ein Kurzschluß auf, so wird ein Kurzschluß der MOSFET-Endstufe 1 beim folgenden Abschaltvorgang detektiert und ein Kurzschluß der MOSFET-Endstufe 2 beim nächsten Einschaltvorgang, so daß nach Ablauf der momentanen Einschaltphase ein Einschalten nicht mehr möglich ist.

In einer Erweiterung der voranstehend beschriebenen Schaltungsanordnung wird die Überwachungslogik für die erste MOSFET-Endstufe 1 derartig ergänzt, daß auch der Fall eines Kurzschlusses der MOSFET-Endstufe 1 mit einer gleichzeitigen Schädigung der zugehörigen Logikschaltung 3 detektiert wird, durch die auch die Eingangsspannung auf High-Potential liegt, so daß die nachgeschaltete MOSFET-Endstufe 2 eingeschaltet und damit die Last 6 aktiviert würde.

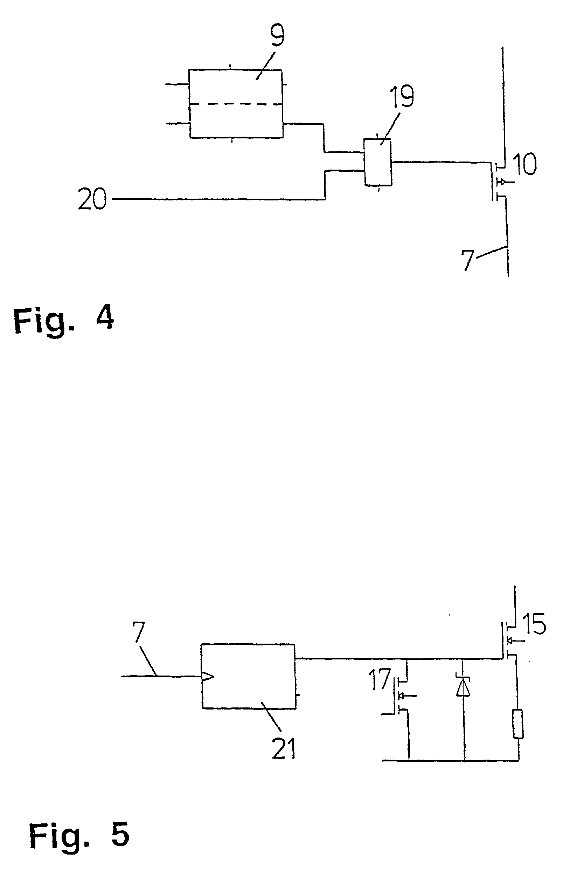

Um auch diesen Fehlerfall abzudecken, werden die in den Fig. 2 und 3 dargestellten Schaltungsteile wie folgt erweitert. Zwischen den Ausgang QN des Flip-Flops 9 und den nachgeschalteten Transistor 10 wird ein OR-Gatter 19 geschaltet, dessen zweiter Eingang mit einem Taktsignal 20 angesteuert wird, was in Fig. 4 dargestellt ist. Dadurch wird die Eingangsspannung EN für die Systemlogik 4 der nachgeschalteten MOSFET-Endstufe 2 getaktet.

Mit dieser getakteten Eingangsspannung EN wird ein flankengetriggertes Monoflop 21 angesteuert, was in Fig. 5 dargestellt ist. Die Einschaltzeit des Monoflop 21 ist auf die Taktfrequenz der getakteten Eingangsspannung 20 abgestimmt.

Liegt nun eine Beschädigung der Systemlogik 3 der ersten MOSFET-Endstufe 1 vor, so daß die Eingangsspannung immer auf High-Potential liegt, so können keine Schaltflanken im Signal der Eingangsspannung EN detektiert werden. In diesem Falle wird die Last 6 nach Ablauf der Monoflop-Zeitkonstante abgeschaltet.

Zusammenfassend sei hier noch einmal festgestellt, daß die erfindungsgemäße Schaltungsanordnung eine gegenseitige Überwachung auf Kurzschluß der beiden in Reihe geschalteten MOSFET-Endstufen realisiert. Die Überwachung der nachgeschalteten MOSFET-Endstufe beruht auf dem Prinzip der Lastüberwachung, wobei eine hochohmige Last dem Normalzustand entspricht, während eine niederohmige Last den Kurzschluß der nachgeschalteten MOSFET-Endstufe signalisiert. Die Überwachung der ersten MOSFET-Endstufe beruht auf einem Vergleich zwischen der Eingangsspannung und der Versorgungsspannung der nachgeschalteten MOSFET-Endstufe.

## Patentansprüche

1. Schaltungsanordnung zum Schalten von Lasten aufgrund eines Einschaltsignals (INPUT-5), mit mindestens zwei in Reihe geschalteten, jeweils über eine Logikschaltung (3, 4) ansteuerbaren MOSFET-Endstufen (1, 2), wobei die Spannungsversorgung der nachgeschalteten zweiten MOSFET-Endstufe (2) über die erste MOSFET-Endstufe (1) erfolgt, **dadurch gekennzeichnet, daß** eine Verbindungsleitung (7) zwischen den Logikschaltungen (3, 4) vorgesehen ist, über die eine Eingangsspannung (EN) an der Logikschaltung (4) der nachgeschalteten MOSFET-Endstufe (2) anliegt, daß Mittel (8, 9, 12, 13) zum Überwachen der Versorgungsspannung (LOAD1) der nachgeschalteten MOSFET-Endstufe (2) vorgesehen sind, wobei diese Mittel durch das Einschaltsignal (INPUT-5) aktiviert werden und ein Einschalten der ersten MOSFET-Endstufe (1) verhindern, wenn die Versorgungsspannung (LOAD1) unterhalb eines vorbestimmten Wertes liegt, z.B. beim Kurzschluß der nachgeschalteten MOSFET-Endstufe (2), daß Mittel (10) vorgesehen sind zum Verändern der Eingangsspannung (EN), wenn die erste MOSFET-Endstufe (1) aufgrund des Einschaltsignals (INPUT-5) eingeschaltet wird, und daß Mittel (15, 16, 17) zum Einschalten der nachgeschalteten MOSFET-Endstufe vorgesehen sind, wobei die Mittel (15, 16, 17) Ansteuermittel (16, 17) aufweisen, die mit der Verbindungsleitung (7) und mit der die MOSFET-Endstufen verbindenden, und die Versorgungsspannung (LOAD1) liefernden Leitung (11) derart verbunden sind, daß ein Einschalten der nachgeschalteten MOSFET-Endstufe (2) verhindert wird, wenn die Versorgungsspannung ein bestimmtes Potential überschreitet, bevor das Vorliegen des Einschaltsignals erkannt wird.

2. Schaltungsanordnung nach Anspruch 1, **dadurch gekennzeichnet, daß** eine Systemlogik (3) der ersten MOSFET-Endstufe (1) Mittel zum Takten der Eingangsspannung (EN) umfaßt und daß die Systemlogik (4) der nachgeschalteten MOSFET-Endstufe (2) Mittel zum Überwachen der Eingangsspannung (EN) umfaßt, wobei diese Mittel ein Einschalten der zweiten MOSFET-Endstufe (2) verhindern, wenn im Signal der Eingangsspannung (EN) keine Schaltflanken detektiert werden.

3. Schaltungsanordnung nach einem der Ansprüche 1 und 2, **dadurch gekennzeichnet, daß** die Mittel zum Überwachen der Versorgungsspannung (LOAD1) der nachgeschalteten MOSFET-Endstufe (2) umfassen;
- einen ersten Transistor (8), der parallel zu der ersten MOSFET-Endstufe (1) geschaltet ist und durch das Einschaltsignal (INPUT-5) eingeschaltet wird, während die erste MOSFET-Endstufe (1) zunächst noch ausgeschaltet bleibt,
- einen Operationsverstärker (12), an dessen Eingängen die Versorgungsspannung (LOAD1) und eine Vergleichsspannung (Vs-13) anliegen, und
- ein dem Operationsverstärker (12) nachgeschaltetes Flip-Flop (9), über das die erste MOSFET-Endstufe (1) eingeschaltet wird, wenn die Versorgungsspannung (LOAD1) oberhalb der Vergleichsspannung (Vs-13) liegt.

4. Schaltungsanordnung nach Anspruch 3, **dadurch gekennzeichnet, daß** die Eingangsspannung (EN) über das Flip-Flop (9) verändert wird, wenn die erste MOSFET-Endstufe (1) über das Flip-Flop (9) eingeschaltet wird.

5. Schaltungsanordnung nach einem der Ansprüche 3 oder 4, **dadurch gekennzeichnet, daß** der nachgeschalteten MOSFET-Endstufe (2) ein zweiter Transistor (15) vorgeschaltet ist, der zwischen die Versorgungsspannung (LOAD1) und die Eingangsspannung (EN) geschaltet ist, so daß die nachgeschaltete MOSFET-Endstufe (2) eingeschaltet wird, wenn sowohl die Eingangsspannung (EN) als auch die Versorgungsspannung (LOAD1) jeweils ein bestimmtes Potential überschreiten.

6. Schaltungsanordnung nach Anspruch 5, **dadurch gekennzeichnet, daß** der nachgeschalteten MOSFET-Endstufe (2) ein dritter Transistor (16) vorgeschaltet ist, der ein Einschalten der MOSFET-Endstufe (2) verhindert, wenn zwar die Versorgungsspannung (LOAD1) ein bestimmtes Potential überschreitet, die Eingangsspannung (EN) aber unter einem bestimmten Potential liegt.

7. Schaltungsanordnung nach Anspruch 6, **dadurch gekennzeichnet, daß** Mittel (18) vorgesehen sind, die eine gleichzeitige Aktivierung des zweiten und des dritten Transistors (15, 16) verhindern.

8. Schaltungsanordnung nach einem der Ansprüche 3 bis 7, **dadurch gekennzeichnet, daß** als Mittel zum Takten der Eingangsspannung (EN) ein dem Flip-Flop (9) nachgeschaltetes OR-Gatter (19) dient, dessen zweiter Eingang mit einem Taktsignal (20) angesteuert wird, und daß die Mittel zum Überwachen der Eingangsspannung (EN) ein flankengetriggertes Monoflop (21) umfassen, dessen Einschaltzeit auf die Taktfrequenz des Taktsignals (20) abgestimmt ist.

9. Verwendung einer Schaltung nach einem der Ansprüche 1 bis 8 zum Schalten von sicherheitsrelevanten Lasten im Kfz-Bereich.

## Claims

1. Circuit arrangement for the switching of loads on account of a switch-on signal (INPUT-5), having at least two series-connected MOSFET output stages (1, 2) which can be respectively driven via a logic circuit (3, 4), the voltage supply of the downstream-connected second MOSFET output stage (2) being effected via the first MOSFET output stage (1), **characterized in that** a connecting line (7) is provided between the logic circuits (3, 4), via which an input voltage (EN) is present at the logic circuit (4) of the downstream-connected MOSFET output stage (2), **in that** means (8, 9, 12, 13) for monitoring the supply voltage (LOAD1) of the downstream-connected MOSFET output stage (2) are provided, these means being activated by the switch-on signal (INPUT-5) and preventing the first MOSFET output stage (1) from being switched on if the supply voltage (LOAD1) lies below a predetermined value, e.g. in the event of a short circuit of the downstream-connected MOSFET output stage (2), **in that** means (10) are provided for changing the input voltage (EN) if the first MOSFET output stage (1) is switched on on account of the switch-on signal (INPUT-5) and **in that** means (15, 16, 17) for switching on the downstream-connected MOSFET output stage are provided, the means (15, 16, 17) having drive means (16, 17) which are connected to the connecting line (7) and to the line (11), which connects the MOSFET output stages and supplies the supply voltage (LOAD1), in such a way that the downstream-connected MOSFET output stage (2) is prevented from being switched on if the supply voltage exceeds a specific potential before the presence of the switch-on signal is identified.

2. Circuit arrangement according to Claim 1, **characterized in that** a system logic unit (3) of the first MOSFET output stage (1) comprises means for clocking the input voltage (EN), and **in that** the system logic unit (4) of the downstream-connected MOSFET output stage (2) comprises means for monitoring the input voltage (EN), these means preventing the second MOSFET output stage (2) from being switched on if no switching edges are detected in the signal of the input voltage (EN).

3. Circuit arrangement according to either of Claims 1 and 2, **characterized in that** the means for monitoring the supply voltage (LOAD1) of the downstream-connected MOSFET output stage (2) comprise;
- a first transistor (8), which is connected in parallel with the first MOSFET output stage (1) and is switched on by the switch-on signal (INPUT-5), while the first MOSFET output stage (1) initially still remains switched-off,
- an operational amplifier (12), at whose inputs the supply voltage (LOAD1) and a comparison voltage (Vs-13) are present, and
- a flip-flop (9), which is connected downstream of the operational amplifier (12) and via which the first MOSFET output stage (1) is switched on if the supply voltage (LOAD1) lies above the comparison voltage (Vs-13).

4. Circuit arrangement according to Claim 3, **characterized in that** the input voltage (EN) is changed via the flip-flop (9) if the first MOSFET output stage (1) is switched on via the flip-flop (9).

5. Circuit arrangement according to either of Claims 3 and 4, **characterized in that** a second transistor (15) is connected upstream of the downstream-connected MOSFET output stage (2), which transistor is connected between the supply voltage (LOAD1) and the input voltage (EN), with the result that the downstream-connected MOSFET output stage (2) is switched on if both the input voltage (EN) and the supply voltage (LOAD1) in each case exceed a specific potential.

6. Circuit arrangement according to Claim 5, **characterized in that** a third transistor (16) is connected upstream of the downstream-connected MOSFET output stage (2), which transistor prevents the MOSFET output stage (2) from being switched on if, although the supply voltage (LOAD1) exceeds a specific potential, the input voltage (EN) nonetheless lies below a specific potential.

7. Circuit arrangement according to Claim 6, **characterized in that** means (18) are provided, which prevent simultaneous activation of the second and third transistors (15, 16).

8. Circuit arrangement according to one of Claims 3 to 7, **characterized in that** an OR gate (19), which is connected downstream of the flip-flop (9) and whose second input is driven by a clock signal (20), serves as the means for clocking the input voltage (EN), and **in that** the means for monitoring the input voltage (EN) comprise an edge-triggered monostable multivibrator (21) whose switch-on time is co-ordinated with the clock frequency of the clock signal (20).

9. Use of a circuit according to one of Claims 1 to 8, for the switching of safety-relevant loads in the automotive field.

## Revendications

1. Circuit de commutation de charges sur la base d'un signal de branchement (INPUT 5) comportant au moins deux étages de puissance MOSFET (1, 2) commandés chacun par un circuit logique (3, 4), l'alimentation en tension du second étage de puissance MOSFET (2) branché en aval se faisant par l'intermédiaire du premier étage de puissance MOSFET (1),
**caractérisé en ce qu'**
il est prévu une ligne de liaison (7) entre les circuits logiques (3, 4) pour appliquer une tension d'entrée (EN) au circuit logique (4) de l'étage de puissance MOSFET (2) branché en aval,
des moyens (8, 9, 12, 13) pour surveiller la tension d'alimentation (CHARGE 1) de l'étage de puissance MOSFET (2) en aval, ces moyens étant activés par le signal de branchement d'entrée (INPUT 5) et doivent éviter le branchement du premier étage de puissance MOSFET (1) si la tension d'alimentation en (CHARGE 1) se situe en dessous d'une valeur prédéterminée, par exemple en cas de court-circuit de l'étage de puissance MOSFET (2) en aval,
des moyens (10) pour modifier la tension d'entrée (EN) si du fait du signal d'entrée (INPUT 5) le premier étage de puissance MOSFET (1) est mis en oeuvre, et
des moyens (15, 16, 17) pour brancher les étages de puissance MOSFET en aval, ces moyens (15, 16, 17) comprenant des moyens de commande (16, 17) connectés de telle sorte à la ligne de liaison (7) et à la ligne (11) reliant les étages de puissance MOSFET et fournissant la tension d'alimentation (CHARGE 1), que la mise en oeuvre de l'étage de puissance MOSFET en aval (2) est interdite si la tension d'alimentation dépasse un certain potentiel avant que ne soit détectée l'existence du signal de branchement.

2. Circuit selon la revendication 1,
**caractérisé en en qu'**
une logique de système (3) du premier étage de puissance MOSFET (1) comprend des moyens pour cadencer la tension d'entrée (EN), et la logique du système (4) de l'étage de puissance MOSFET (2) en aval comprend des moyens pour surveiller la tension d'entrée (EN), ces moyens évitant le branchement du second étage de puissance MOSFET (2) si dans le signal de tension d'entrée (EN) on ne détecte pas de flanc de commutation.

3. Circuit selon l'une quelconque des revendications 1 et 2,
**caractérisé en ce que**
les moyens de surveillance de la tension d'alimentation (CHARGE 1) de l'étage de puissance MOSFET (2) en aval comprennent,
- un premier transistor (8) branché en parallèle sur le premier étage de puissance MOSFET (1) et qui branche le signal de branchement (INPUT 5) alors que le premier étage de puissance MOSFET (1) reste d'abord encore coupé,
- un amplificateur opérationnel (12) dont les entrées reçoivent la tension d'alimentation (CHARGE 1) et une tension de comparaison (Vs-13), et
- un Flip-Flop (9) en aval de l'amplificateur opérationnel (12) qui branche le premier étage de puissance MOSFET (1) si la tension d'alimentation (CHARGE 1) est supérieure à la tension de comparaison (Vs-13).

4. Circuit selon la revendication 3,
**caractérisé en ce que**
la tension d'entrée (EN) est modifiée par le Flip-Flop (9) si le premier étage de puissance MOSFET (1) est branché par le Flip-Flop (9).

5. Circuit selon l'une quelconque des revendications 3 ou 4,
**caractérisé en ce que**
l'étage de puissance MOSFET en aval (2) est précédé d'un second transistor (15) entre la tension d'alimentation (CHARGE 1) et la tension d'entrée (EN) pour que l'étage de puissance MOSFET (2) branché en aval soit mis en oeuvre si à la fois la tension d'entrée (EN) et la tension d'alimentation en charge (1) dépassent chacune un certain potentiel.

6. Circuit selon la revendication 5,
**caractérisé en ce que**
l'étage de puissance MOSFET (2) en aval est précédé par un troisième transistor (16) qui interdit le branchement de l'étage de puissance MOSFET (2) si la tension d'alimentation (CHARGE 1) dépasse un certain potentiel mais si la tension d'entrée (EN) est en dessous d'un certain potentiel.

7. Circuit selon la revendication 6,
**caractérisé par**
des moyens (18) qui interdisent une activation simultanée du second et du troisième transistor (15, 16).

8. Circuit selon l'une quelconque des revendications 3 à 7,
**caractérisé en ce que**
les moyens pour cadencer la tension d'entrée (EN) sont constitués par une porte OU (19) en aval du Flip-Flop (9), porte dont la seconde entrée est commandée par un signal de cadence (20) et avec des moyens pour surveiller la tension d'entrée (EN) comprenant une bascule monoflop (21) déclenchée par le flanc du signal et dont la durée de fermeture est accordée suivant la fréquence du signal de cadence (20).

9. Application d'un circuit selon l'une quelconque des revendications 1 à 8 pour commuter des charges concernant la dans le domaine des véhicules automobiles.
